# EUROPÄISCHE PATENTSCHRIFT

(11) **EP 2 427 965 B1**
(45) Veröffentlichungstag und Bekanntmachung des Hinweises auf die Patenterteilung: **23.11.2016**
(21) Anmeldenummer: 10718030.9
(22) Anmeldetag: 19.04.2010
(51) Int. Cl.: H03K 17/16, H03K 17/687, H02M 1/38, H03K 17/567, H03K 19/003

(54) **VERFAHREN UND VORRICHTUNG ZUM SCHUTZ VON TRANSISTOREN**
METHOD AND APPARATUS FOR PROTECTING TRANSISTORS
PROCÉDÉ ET DISPOSITIF DE PROTECTION DES TRANSISTORS

(30) Priorität: 08.05.2009 AT 7062009
(43) Veröffentlichungstag der Anmeldung: 14.03.2012
(73) Patentinhaber: Fronius International GmbH, 4643 Pettenbach (AT)
(72) Erfinder: PIRCHENFELLNER, Jürgen, A-4224 Wartberg/Aist (AT); ACHLEITNER, Günter, A-4642 Sattledt (AT); HOLZINGER, Stephan, A-4664 Scharnstein (AT); PAMMER, Walter, A-4540 Bad Hall (AT)
(74) Vertreter: Sonn & Partner Patentanwälte
(86) Internationale Anmeldenummer: PCT/AT2010/000118
(87) Internationale Veröffentlichungsnummer: WO 2010/127374

(56) Entgegenhaltungen:
- US-A1- 2002 105 311
- US-A1- 2005 258 890
- US-A1- 2008 246 519

## Beschreibung

Die Erfindung betrifft ein Verfahren zum Schutz von in zumindest einem Pfad angeordneten Transistoren mit parallelen Freilaufdioden, wobei in einem Pfad zwei in Serie geschaltete Transistoren angeordnet werden, an welchen eine Eingangsspannung angelegt wird, und die Transistoren eines Pfades abwechselnd zwischen einem leitenden Zustand und einem sperrenden Zustand zur Erzeugung einer Ausgangsspannung im Mittelpunkt des Pfades umgeschaltet werden, und zum Schutz vor einem gleichzeitigen leitenden Zustand der in Serie geschalteten Transistoren vor einer Umschaltung eines Transistors in den leitenden Zustand der sperrende Zustand des zweiten Transistors überprüft wird.

Ebenso betrifft die Erfindung eine Vorrichtung zum Schutz von in zumindest einem Pfad angeordneten Transistoren mit parallelen Freilaufdioden, wobei in einem in einer Eingangsspannung versorgten Pfad zwei in Serie geschaltete Transistoren angeordnet sind, wobei die Transistoren zur abwechselnden Umschaltung zwischen einem leitenden Zustand und einem sperrenden Zustand zur Erzeugung einer im Mittelpunkt des Pfades gebildeten Ausgangsspannung angeordnet sind, wobei zum Schutz vor einem gleichzeitigen leitenden Zustand der in Serie geschalteten Transistoren zumindest eine Messvorrichtung für jeden Pfad angeordnet ist, die zur Überprüfung des sperrenden Zustands eines Transistors vor einer Umschaltung des zweiten Transistors in den leitenden Zustand ausgebildet ist.

Die US 5 737 169 A zeigt eine Schaltung zum Schutz eines Feldeffekttransistors vor Überhitzung, wobei die Drain-Spannung ermittelt und bei Überschreitung eines Schwellwerts der Gate-Anschluss des Transistors gesperrt wird. Ein gleichzeitiges Durchschalten zweier in einem Pfad in Serie angeordneter Transistoren kann mit dieser Schaltung nicht verhindert werden.

Die US 2005/258890 A1 offenbart eine elektronische Schaltung, durch welche ein gleichzeitiges Schalten zweier in Serie angeordneter Transistoren in den leitenden Zustand verhindert wird. Mit dieser Schaltung kann jedoch nicht ein eigenes Aufsteuern bzw. Schalten eines Transistors mit paralleler Freilaufdiode in den leitenden Zustand aufgrund interner Kapazitäten verhindert werden. Dabei wird der eine Transistor dann in den leitenden Zustand geschaltet, wenn die Diode des zweiten in Serie geschalteten Transistors leitet.

Die US 2002/105311 A1 zeigt das Schalten von Transistoren in Abhängigkeit bestimmter Spannungspegel. Ein gleichzeitiger leitender Zustand von in Serie geschalteten Transistoren wird nicht verhindert.

Die Aufgabe der Erfindung liegt darin, zwei in Serie geschaltete Transistoren, welche abwechselnd zwischen einem leitenden und sperrenden Zustand umgeschaltet werden, vor einem gleichzeitigen Schalten in den leitenden Zustand zu schützen. Weiters soll vermieden werden, dass interne Kapazitäten der Transistoren zu einem eigenen Aufsteuern bzw. Schalten in den leitenden Zustand führen.

Die Aufgabe der Erfindung wird in verfahrensmäßiger Hinsicht dadurch gelöst, dass im sogenannten nichtregulären Betrieb, wenn sich alle Transistoren im sperrenden Zustand befinden, der Zustand der Freilaufdiode des zweiten Transistors überprüft wird, und die Umschaltung des einen Transistors in den leitenden Zustand mit einem bei dieser Überprüfung generierten Signal freigegeben wird, und die Umschaltung des einen Transistors in den leitenden Zustand verhindert wird, wenn ein leitender Zustand der Freilaufdiode des zweiten Transistors festgestellt wird. Dadurch dass der Umschaltvorgang des Transistors in Abhängigkeit des Zustands des weiteren im Pfad angeordneten Transistors durchgeführt wird, kann sichergestellt werden, dass sich die beiden in Serie geschalteten Transistoren keinesfalls gleichzeitig im leitenden Zustand befinden, und somit ein Kurzschluss vermieden werden. In der Folge kann der Einsatz von Transistoren bei verschiedenen Anwendungen ermöglicht werden und somit die Verlustleistung minimiert und der Wirkungsgrad erhöht werden. Ebenso kann ein zuverlässiger Betrieb der mit den Transistoren aufgebauten Schaltung sichergestellt werden, da die Transistoren nur zu bestimmten Zeitpunkten leitend geschaltet werden, sodass ein undefiniertes Verhalten der Schaltung ausgeschlossen ist. Erfindungsgemäß wird der Zustand der Freilaufdiode des zweiten Transistors überprüft bevor der in Serie geschaltete Transistor leitend geschaltet wird.

Vorteilhafterweise wird die Überprüfung des Zustands der Freilaufdiode des zweiten Transistors bei zumindest zwei sperrenden Transistoren eines Pfades mit einer Spannungsmessung an der Freilaufdiode des zweiten Transistors und einer Auswerteschaltung durchgeführt.

Bei der Überprüfung kann das Potential im Mittelpunkt des Pfades durch einen der Freilaufdiode des zweiten Transistors parallel geschalteten Spannungsteiler vordefiniert werden. Dadurch wird ein definiertes Potential als Ausgangspunkt für die Überprüfung geschaffen.

Gemäß einem weiteren Merkmal der Erfindung wird das vordefinierte Potential mit einer Referenzspannung verglichen und dadurch das Signal generiert, welches zur Freigabe der Umschaltung des Transistors herangezogen wird.

Gelöst wird die erfindungsgemäße Aufgabe auch durch eine oben genannte Vorrichtung, bei der die Messvorrichtung zur Messung des leitenden Zustands der Freilaufdiode des zweiten Transistors im sogenannten nichtregulären Betrieb, wenn sich alle Transistoren im sperrenden Zustand befinden, ausgebildet und mit einer Steuerung für die Transistoren verbunden ist, und die Messvorrichtung zur Generierung eines Signals in Abhängigkeit der Erfassung des leitenden Zustands der Freilaufdiode des zweiten Transistors für die Umschaltung eines Transistors ausgebildet ist. Eine derartige Schutzvorrichtung bzw. Schutzschaltung zeichnet sich durch besondere Einfachheit aus.

Wenn ein Potential im Mittelpunkt des Pfades durch einen der Freilaufdiode des zweiten Transistors parallel geschalteten Spannungsteiler vordefiniert ist, und der Spannungsteiler mit der Messvorrichtung verbunden ist, sodass das vordefinierte Potential der Messvorrichtung zugeführt wird, kann sichergestellt werden, dass die Überprüfungsschaltung nicht unerwünscht ein Freigabesignal generiert. Dies kann beispielsweise beim Hochstarten oder bei kleinen Leistungen auftreten.

Vorteilhafterweise ist ein Transistor in einem Pfad durch einen Insulated Gate Bipolar Transistor (IGBT) oder Metall-Oxid-Halbleiter-Feldeffekttransistor (MOSFET) gebildet und der zweite Transistor des Pfades durch einen Metall-Oxid-Halbleiter-Feldeffekttransistor (MOSFET) gebildet.

Die vorliegende Erfindung wird anhand der beigefügten, schematischen Zeichnungen näher erläutert.

Darin zeigen:
- Fig. 1: eine schematische Darstellung einer bekannten Vollbrücke mit Transistoren als Schaltelemente; und
- Fig. 2: eine schematische Darstellung einer Vollbrücke mit dem erfindungsgemäßen Schutz für die Transistoren.

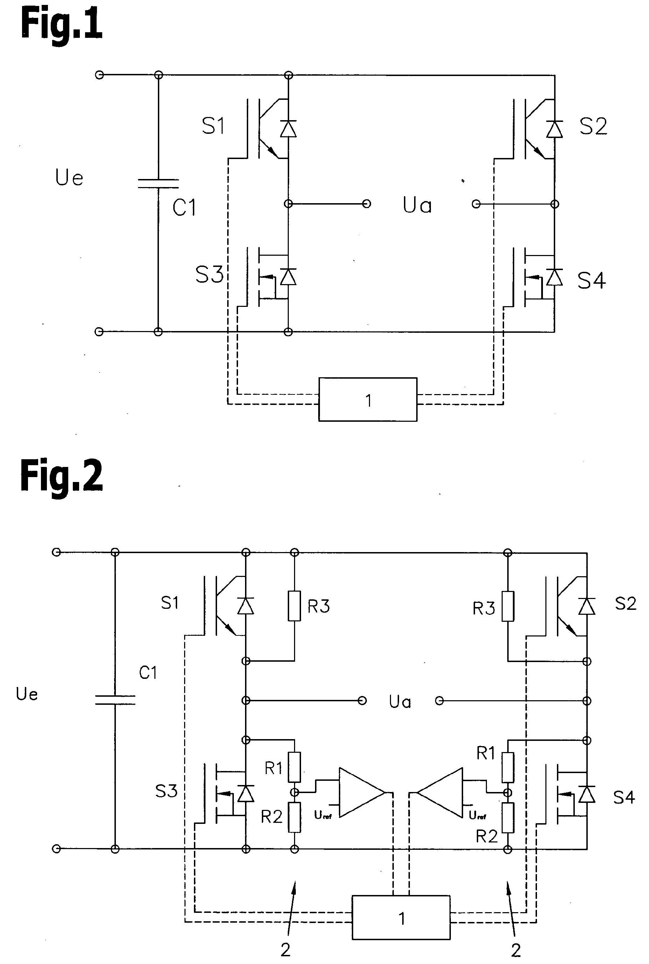

Wie aus Fig. 1 ersichtlich, wird eine durch eine Vollbrücke gebildete Ausgangsstufe durch einen ersten Pfad, umfassend die Transistoren S1 und S3, und einen zweiten Pfad, umfassend die Transistoren S2 und S4, gebildet. Die Transistoren eines Pfades sind in Serie geschaltet. Aus der Eingangsspannung Ue wird eine zwischen den Mittelpunkten der Pfade abgreifbare Ausgangsspannung Ua erzeugt. Dazu werden die Transistoren eines Pfades gegengleich bzw. abwechselnd von einer Steuerung 1 angesteuert. Bei der beispielhaft gezeigten Vollbrücke werden demnach jeweils zwei Transistoren von unterschiedlichen Pfaden gleichzeitig angesteuert. Die Anzahl der gleichzeitig angesteuerten Transistoren ist auf die verwendete Schaltung (Vollbrücke, Einweggleichrichter, Brückengleichrichter oder dergl.) entsprechend abgestimmt. Bei der dargestellten Vollbrücke wird aus der am Kondensator C1 anliegenden Gleichspannung als Eingangsspannung Ue vom Zwischenkreis eines Wechselrichters über die Transistoren S1 & S4 eine positive Halbwelle einer Ausgangsspannung Ua erzeugt und über die Transistoren S2 & S3 eine negative Halbwelle. Dabei sind bei der Erzeugung der positiven Halbwelle die Transistoren S1 & S4 leitend und die Transistoren S2 & S3 gesperrt. Zur Erzeugung der negativen Halbwelle werden von der Steuerung 1 die Transistoren entsprechend umgeschaltet, sodass die Transistoren S1 & S4 sperren und die Transistoren S2 & S3 leiten. Somit wird eine Wechselspannung als Ausgangsspannung Ua erzeugt, die in das Netz eingespeist werden kann, wie es bei Wechselrichtern aus dem Stand der Technik bekannt ist. Beim Umschaltvorgang zu definierten Umschaltzeitpunkten sind kurzzeitig die Transistoren S1 bis S4 gesperrt, sodass im Wesentlichen das Potential vom Netz bestimmt wird und sich die Ausgangsstufe in einem sogenannten nichtregulären Betrieb befindet. Somit können auch entsprechende Störungen vom Netz ein Potential im Mittelpunkt des Pfades bewirken, bei welchem die Freilaufdioden der Transistoren S1 bis S4 leiten. Ebenso können die Freilaufdioden auch durch deren sogenannte "Reverse Recovery"-Eigenschaft in Sperrrichtung leitend werden, indem eine hohe Stromänderung di/dt durch das Schalten des dazu in Serie geschalteten Transistors in den leitenden Zustand verursacht wird. Durch interne Kapazitäten des Transistors kann die daraus resultierende schnelle Änderung der Drain-Spannung zum eigenen Aufsteuern bzw. Schalten in den leitenden Zustand führen. Gegebenenfalls kann dies zu einem Kurzschluss von C1 bzw. der Eingangsspannung Ue führen, wenn beispielsweise der Transistor S1 (S2) leitend geschaltet wird, wenn die Freilaufdiode des Transistors S3 (S4) durch das vom Netz bewirkte Potential leitend ist. Dies würde zu einer Zerstörung der Transistoren führen. Die Freilaufdiode ist dabei insbesondere bei der Verwendung von Transistoren wie MOSFET's eine interne Diode, welche aus dem Lagenaufbau der Strukturen dieser Transistoren resultiert, wie allgemein aus dem Stand der Technik bekannt.

Zur Vermeidung eines oben genannten Zustands ist erfindungsgemäß vorgesehen, dass der Zustand der Freilaufdiode der Transistoren S3 bzw. S4 überprüft wird, bevor die im Pfad in Serie geschalteten Transistoren S1 bzw. S2 leitend geschaltet werden. Dazu erfolgt, wie aus Fig. 2 ersichtlich, zum einen eine Vordefinierung des Potentials der Eingangsspannung Ue im Mittelpunkt des Pfades - beispielsweise eine Symmetrisierung bzw. Halbierung von 350 V auf 175 V, sodass im Wesentlichen zwischen den Transistoren S1 und S3 das halbe Potential der Eingangsspannung Ue anliegt. Dies kann durch einen Spannungsteiler mit zwei Widerständen R1 und R3 erfolgen. Da diese Widerstände durch das Schalten der Transistoren in den leitenden Zustand kurzgeschlossen werden, erfolgt die Vordefinierung des Potentials nur im nichtregulären Betrieb. Damit nun eine im nichtregulären Betrieb hervorgerufene Veränderung des dadurch definierten Potentials überwacht werden kann, ist zum zweiten eine Messvorrichtung 2 mit einer Spannungsmessung vorgesehen. Diese Spannungsmessung wird bevorzugt an den Transistoren S3 & S4 durchgeführt, sodass die Transistoren S1 & S2 nicht leitend geschaltet werden können, falls die Freilaufdioden der Transistoren S3 & S4 durch eine Änderung des Potentials leitend werden würden. Die Spannungsmessung misst also beispielsweise die Drain-Source-Spannung eines MOSFET's bzw. das vordefinierte Potential, welche(s) ein Indiz für die Leitfähigkeit der Freilaufdiode des Transistors ist. Wenn also das Potential sinkt, erkennt dies die Spannungsmessung, welche im nichtregulären Betrieb ständig das Potential misst. Ebenso generiert die Messvorrichtung 2 aus der Spannungsmessung und einer Auswerteschaltung - beispielsweise einem Komparator - ein Signal. Dieses Signal kann insbesondere ein Rechtecksignal sein, aus dessen Zustand (HIGH oder LOW) die Steuerung 1 die Information entnehmen kann, ob der Transistor S1 (S2) leitend geschaltet werden kann.

Die Spannungsmessung wird dabei durch einen Spannungsteiler gebildet, welcher die Spannung eines zu R1 in Serie geschalteten Widerstandes R2, welcher wesentlich kleiner als der Widerstand R1 ist und somit das definierte Potential entsprechend reduziert, einem Komparator liefert. Diese an R2 gemessene Spannung vergleicht der Komparator mit einer Referenzspannung U_{ref}, und generiert das Signal. Ist die an R2 gemessene Spannung kleiner als die Referenzspannung U_{ref}, weist der Ausgang des Komparators und somit das generierte Signal einen LOW-Zustand auf. Ist hingegen die an R2 gemessene Spannung größer als die Referenzspannung U_{ref}, hat der Ausgang und somit das generierte Signal einen HIGH-Zustand, welcher dem Freigabe-Zustand für die Umschaltung des Transistors S1 (S2) entspricht. Ist demnach das Potential unter einen eingestellten Schwellwert (beispielsweise 90V) gesunken, hat das generierte Rechtecksignal einen LOW-Zustand. Fällt nun der definierte Umschaltzeitpunkt auf einen solchen Zeitpunkt des Rechtecksignals, wird der Transistor S1 (S2) nicht leitend geschaltet - also die Umschaltung nicht freigegeben. Dies ist darauf zurückzuführen, dass erkannt wurde, dass das Potential eine sinkende Tendenz aufweist, wodurch die Freilaufdiode des Transistors in Kürze leitend werden würde. Demzufolge wartet die Steuerung 1, bis das Signal einen HIGH-Zustand liefert, sodass die Umschaltung durchgeführt werden kann. Es wird also der Umschaltzeitpunkt, beispielsweise auf den nächsten definierten Umschaltzeitpunkt verschoben. Liegt hingegen das Potential zum Umschaltzeitpunkt über dem Schwellwert, wird der Transistor S1 (S2) leitend geschaltet, also die Umschaltung freigegeben.

Mit einer derartigen Spannungsmessung - insbesondere durch die ständige Messung des Potentials - kann eine schnelle Änderung der Spannung erfasst werden, sodass auch Änderungen im Nanosekunden-Bereich erfasst werden können. Derart schnelle Änderungen der Spannung werden insbesondere durch Unsymmetrien und überlagerte "Surges", wie Blitze und Überspannungen der Wechselspannung im Nulldurchgang hervorgerufen.

Mit dem erfindungsgemäßen Verfahren und der erfindungsgemäßen Vorrichtung kann also sichergestellt werden, dass der Transistor S1 (S2) nur dann leitend geschaltet wird, wenn der zweite Transistor S3 (S4) des Pfades gesperrt ist. Somit wird auch bei schnellen Änderungen des Potentials im nichtregulären Betrieb verhindert, dass ein undefiniertes Schalten der Transistoren erfolgt. Derartige schnelle Änderungen des Potentials im nichtregulären Betrieb entstehen insbesondere durch das gleichzeitige Einschalten der in Serie geschalteten Transistoren, also wenn beim Schalten eines Transistors in den leitenden Zustand die Freilaufdiode des weiteren Transistors leitend ist. Dabei spricht man auch von einem direkten Schalten auf die leitende Freilaufdiode des Transistors. Diese schnellen Änderungen bewirken aufgrund der Drain-Gate-Kapazität des Transistors ein ungewolltes Einschalten des Bauteils. Gemäß der Erfindung erfolgt stets ein sicheres Umschalten der Zustände und es ist gewährleistet, dass der Eingang der Ausgangsstufe - also die Zwischenkreisspannung - nicht kurzgeschlossen wird. Dabei ist das erfindungsgemäße Verfahren unabhängig davon, ob wie im beschriebenen Ausführungsbeispiel eine Gleichspannung in eine Wechselspannung oder eine Wechselspannung in eine Gleichspannung umgewandelt wird.

Das erfindungsgemäße Verfahren ist insbesondere dann von Bedeutung, wenn als Transistoren S3 & S4 solche Typen eingesetzt werden, welche eine äußerst geringe Verlustleistung bewirken. Derartige Transistoren weisen einen sehr geringen Drain-Source On-State-Resistance R_{DS(on)} auf, wodurch sie auf Änderungen des Potentials sehr empfindlich reagieren. Beispielsweise ist dies beim Einsatz von Transistoren des Typs COOLMOS von Advanced Power Technology^{®} der Fall. Aus dem Datenblatt dieses Transistors (siehe www.advancedpower.com) 050-7239 Rev B 3-2006 der Typen APT60N60BCS, APT60N60BCSG, APT60N60SCS, APT60N60SCSG ist zu entnehmen, dass der Einsatz dieser Typen nicht empfohlen wird, wenn schnelle Stromänderungen bzw. Änderungen des Potentials zu erwarten sind. Diese Transistoren ermöglichen jedoch wiederum einen wesentlich besseren Wirkungsgrad, und können gemäß der Erfindung bei Ausgangsstufen von Wechselrichtern, Batterieladegeräten, Schweißgeräten oder dergleichen eingesetzt werden.

## Patentansprüche

1. Verfahren zum Schutz von in zumindest einem Pfad angeordneten Transistoren (S1, S3; S2, S4) mit parallelen Freilaufdioden, wobei in einem Pfad zwei in Serie geschaltete Transistoren (S1, S3; S2, S4) angeordnet werden, an welchen eine Eingangsspannung (Ue) angelegt wird, und die Transistoren (S1, S3; S2, S4) eines Pfades abwechselnd zwischen einem leitenden Zustand und einem sperrenden Zustand zur Erzeugung einer Ausgangsspannung (Ua) im Mittelpunkt des Pfades umgeschaltet werden, und zum Schutz vor einem gleichzeitigen leitenden Zustand der in Serie geschalteten Transistoren (S1, S3; S2, S4) vor einer Umschaltung eines Transistors (S1; S2) in den leitenden Zustand der sperrende Zustand des zweiten Transistors (S3; S4) überprüft wird, **dadurch gekennzeichnet, dass** im sogenannten nichtregulären Betrieb, wenn sich alle Transistoren (S1, S3; S2, S4) im sperrenden Zustand befinden, der Zustand der Freilaufdiode des zweiten Transistors (S3; S4) überprüft wird, und die Umschaltung des einen Transistors (S1; S2) in den leitenden Zustand mit einem bei dieser Überprüfung generierten Signal freigegeben wird, und die Umschaltung des einen Transistors (S1; S2) in den leitenden Zustand verhindert wird, wenn ein leitender Zustand der Freilaufdiode des zweiten Transistors festgestellt wird.

2. Verfahren nach Anspruch 1, **dadurch gekennzeichnet, dass** die Überprüfung des Zustands der Freilaufdiode des zweiten Transistors (S3; S4) bei zumindest zwei sperrenden Transistoren (S1, S3; S2, S4) eines Pfades mit einer Spannungsmessung an der Freilaufdiode des zweiten Transistors (S3; S4) und einer Auswerteschaltung durchgeführt wird.

3. Verfahren nach Anspruch 2, **dadurch gekennzeichnet, dass** bei der Überprüfung das Potential im Mittelpunkt des Pfades durch einen der Freilaufdiode des zweiten Transistors (S3; S4) parallel geschalteten Spannungsteiler vordefiniert wird.

4. Verfahren nach Anspruch 3, **dadurch gekennzeichnet, dass** das vordefinierte Potential mit einer Referenzspannung (U_{ref}) verglichen und dadurch das Signal generiert wird.

5. Vorrichtung zum Schutz von in zumindest einem Pfad angeordneten Transistoren (S1, S3; S2, S4) mit parallelen Freilaufdioden, wobei in einem mit einer Eingangsspannung (Ue) versorgten Pfad zwei in Serie geschaltete Transistoren (S1, S3; S2, S4) angeordnet sind, wobei die Transistoren (S1, S3; S2, S4) zur abwechselnden Umschaltung zwischen einem leitenden Zustand und einem sperrenden Zustand zur Erzeugung einer im Mittelpunkt des Pfades gebildeten Ausgangsspannung (Ua) angeordnet sind, wobei zum Schutz vor einem gleichzeitigen leitenden Zustand der in Serie geschalteten Transistoren (S1, S3; S2, S4) zumindest eine Messvorrichtung (2) für jeden Pfad angeordnet ist, die zur Überprüfung des sperrenden Zustands eines Transistors (S3; S4) vor einer Umschaltung des zweiten Transistors (S1; S2) in den leitenden Zustand ausgebildet ist, **dadurch gekennzeichnet, dass** die Messvorrichtung (2) zur Messung des leitenden Zustands der Freilaufdiode des zweiten Transistors (S3; S4) im sogenannten nichtregulären Betrieb, wenn sich alle Transistoren (S1, S3; S2, S4) im sperrenden Zustand befinden, ausgebildet und mit einer Steuerung (1) für die Transistoren (S1, S3; S2, S4) verbunden ist, und die Messvorrichtung (2) zur Generierung eines Signals in Abhängigkeit der Erfassung des leitenden Zustands der Freilaufdiode des zweiten Transistors (S3; S4) für die Umschaltung eines Transistors (S1; S2) ausgebildet ist.

6. Vorrichtung nach Anspruch 5, **dadurch gekennzeichnet, dass** ein Potential im Mittelpunkt des Pfades durch einen der Freilaufdiode des zweiten Transistors (S3; S4) parallel geschalteten Spannungsteiler vordefiniert ist, und der Spannungsteiler mit der Messvorrichtung (2) verbunden ist, sodass das vordefinierte Potential der Messvorrichtung (2) zugeführt wird.

7. Vorrichtung nach Anspruch 5 oder 6, **dadurch gekennzeichnet, dass** ein Transistor (S1; S2) in einem Pfad durch einen Insulated Gate Bipolar Transistor (IGBT) oder Metall-Oxid-Halbleiter-Feldeffekttransistor (MOSFET) gebildet ist und der zweite Transistor (S3; S4) des Pfades durch einen Metall-Oxid-Halbleiter-Feldeffekttransistor (MOSFET) gebildet ist.

## Claims

1. A method for protecting transistors (S1, S3; S2, S4) with parallel flyback diodes arranged in at least one path, wherein two transistors (S1, S3; S2, S4) connected in series to which an input voltage (Ue) is applied are arranged in a path, and the transistors (S1, S3; S2, S4) of a path are alternately switched between a conductive state and a blocking state in order to generate an output voltage (Ua) at the center of the path, and for the protection against a simultaneous conductive state of the transistors (S1, S3; S2, S4) connected in series, the blocking state of the second transistor (S3; S4) is checked before switching a transistor (S1; S2) into the conductive state, **characterized in that** in the so-called non-regular operation when all transistors (S1, S3; S2, S4) are in the blocking state the state of the flyback diode of the second transistor (S3; S4) is checked and the switching of the one transistor (S1; S2) to the conductive state is released by way of a signal generated during the check, and the switching of the one transistor (S1; S2) to the conductive state is prevented if a conductive state of the flyback diode of the second transistor is detected.

2. The method according to claim 1, **characterized in that** the check of the state of the flyback diode of the second transistor (S3; S4) is carried out at at least two blocking transistors (S1, S3; S2, S4) of a path by way of a voltage measurement at the flyback diode of the second transistor (S3; S4) and an evaluation circuit.

3. The method according to claim 2, **characterized in that** during the check the potential at the center of the path is predefined by a voltage divider connected in parallel with the flyback diode of the second transistor (S3; S4).

4. The method according to claim 3, **characterized in that** the predefined potential is compared with a reference voltage (U_{ref}) and that thereby the signal is generated.

5. An apparatus for protecting transistors (S1, S3; S2, S4) with parallel flyback diodes arranged in at least one path, wherein two transistors (S1, S3; S2, S4) connected in series to which an input voltage (Ue) is applied are arranged in a path, wherein the transistors (S1, S3; S2, S4) are arranged for the alternate switching between a conductive state and a blocking state in order to generate an output voltage (Ua) at the center of the path, wherein for the protection against a simultaneous conductive state of the transistors (S1, S3; S2, S4) connected in series at least one measuring device (2) is arranged for each path, said measuring device (2) being designed for checking the blocking state of one transistor (S3; S4) before switching the second transistor (S1; S2) into the conductive state, **characterized in that** the measuring device (2) is designed for measuring the conductive state of the flyback diode of the second transistor (S3; S4) in the so-called non-regular operation when all transistors (S1, S3; S2, S4) are in the blocking state and is connected with a control (1) for the transistors (S1, S3; S2, S4), and that the measuring device (2) is designed for generating a signal for the switching of a transistor (S1; S2) as a function of the detection of the conductive state of the flyback diode of the second transistor (S3; S4).

6. The apparatus according to claim 5, **characterized in that** a potential is predefined at the center of the path by a voltage divider connected in parallel with the flyback diode of the second transistor (S3; S4), and the voltage divider is connected with the measuring device (2) so that the predefined potential is supplied to the measuring device (2).

7. The apparatus according to claim 5 or 6, **characterized in that** one transistor (S1; S2) in a path is formed by an insulated gate bipolar transistor (IGBT) or a metal-oxide semiconductor field effect transistor (MOSFET), and that the second transistor (S3; S4) of the path is formed by a metal-oxide semiconductor field effect transistor (MOSFET).

## Revendications

1. Procédé pour la protection de transistors (S1, S3 ; S2, S4), disposés dans au moins un trajet, avec des diodes de roue libre parallèles, deux transistors (S1, S3 ; S2, S4) branchés en série, auxquels une tension d'entrée (Ue) est appliquée, étant disposés dans un trajet, et les transistors (S1, S3 ; S2, S4) d'un trajet étant commutés alternativement entre un état conducteur et un état de blocage pour la génération d'une tension de sortie (Ua) au centre du trajet et, pour la protection contre un état conducteur simultané des transistors (S1, S3 ; S2, S4) branchés en série, l'état de blocage du deuxième transistor (S3 ; S4) étant vérifié avant une commutation d'un transistor (S1 ; S2) dans l'état conducteur, **caractérisé en ce que**, dans ce qu'on appelle le fonctionnement non régulier, lorsque tous les transistors (S1, S3 ; S2, S4) se trouvent dans l'état de blocage, l'état de la diode de roue libre du deuxième transistor (S3 ; S4) est vérifié et la commutation d'un transistor (S1 ; S2) dans l'état conducteur est autorisée avec un signal généré lors de cette vérification et la commutation d'un transistor (S1 ; S2) dans l'état conducteur est empêché lorsqu'un état conducteur de la diode de roue libre du deuxième transistor est constaté.

2. Procédé selon la revendication 1, **caractérisé en ce que** la vérification de l'état de la diode de roue libre du deuxième transistor (S3 ; S4) est effectuée dans le cas de deux transistors (S1, S3 ; S2, S4) d'un trajet dans l'état de blocage avec une mesure de tension au niveau de la diode de roue libre du deuxième transistor (S3 ; S4) et d'un circuit d'analyse.

3. Procédé selon la revendication 2, **caractérisé en ce que**, lors de la vérification, le potentiel au centre du trajet est prédéfini par un diviseur de tension branché en parallèle à la diode de roue libre du deuxième transistor (S3 ; S4).

4. Procédé selon la revendication 3, **caractérisé en ce que** le potentiel prédéfini est comparé avec une tension de référence (Uref) et le signal est ainsi généré.

5. Dispositif pour la protection de transistors (S1, S3 ; S2, S4), disposés dans au moins un trajet, avec des diodes de roue libre parallèles, deux transistors (S1, S3 ; S2, S4) branchés en série étant disposés dans un trajet alimenté avec une tension d'entrée (Ue), les transistors (S1, S3 ; S2, S4) étant disposés, pour une commutation alternative entre un état conducteur et un état de blocage pour la génération d'une tension de sortie (Ua) formée au centre du trajet, au moins un dispositif de mesure (2) étant prévu pour chaque trajet pour la protection d'un état conducteur simultané des transistors (S1, S3 ; S2, S4) branchés en série, qui est conçu pour la vérification de l'état de blocage d'un transistor (S3 ; S4) avant une commutation du deuxième transistor (S1 ; S2) dans l'état conducteur, **caractérisé en ce que** le dispositif de mesure (2) est conçu pour la mesure de l'état conducteur de la diode à roue libre du deuxième transistor (S3 ; S4) dans ce qu'on appelle le fonctionnement non régulier, lorsque tous les transistors (S1, S3 ; S2, S4) se trouvent dans l'état de blocage et est relié avec un dispositif de commande (1) pour les transistors (S1, S3 ; S2, S4) et le dispositif de commande (2) est conçu pour la génération d'un signal en fonction de la détection de l'état conducteur de la diode de roue libre du deuxième transistor (S3 ; S4) pour la commutation d'un transistor (S1 ; S2).

6. Dispositif selon la revendication 5, **caractérisé en ce qu'**un potentiel au centre du trajet est prédéfini par un diviseur de tension branché en parallèle à la diode de roue libre du deuxième transistor (S3 ; S4) et le diviseur de tension est relié avec le dispositif de mesure (2) de façon à ce que le potentiel prédéfini soit appliqué au dispositif de mesure (2).

7. Dispositif selon la revendication 5 ou 6, **caractérisé en ce qu'**un transistor (S1 ; S2) est constitué dans un trajet d'un Insulated Gate Bipolar Transistor (IGBT) ou un transistor à effet de champ à semi-conducteur à oxyde métallique (MOSFET) et le deuxième transistor (S3 ; S4) du trajet est constitué d'un transistor à effet de champ à semi-conducteur à oxyde métallique (MOSFET).
